# EUROPEAN PATENT APPLICATION

(11) **EP 2 180 610 A1**
(43) Date of publication of application: **28.04.2010**
(21) Application number: 08305714.1
(22) Date of filing: 23.10.2008
(51) Int. Cl.: H04B 10/12, H03F 3/38, H03F 3/217

(54) **A method for transmission of signals, a switched mode power amplifier, a transmitting device, a receiving device, and a communication network therefor**

(71) Applicant: Alcatel Lucent, 75008 Paris (FR)
(72) Inventor: Templ, Wolfgang, 74372, Sersheim (DE)
(74) Representative: Brose, Gerhard

(57) **Abstract**

The invention concerns a method for transmission of signals from a transmitting device (BS) to at least one receiving device (RAH1) using a switched mode power amplifier (PA) for signal amplification, wherein the signals are modulated in a first part of the switched mode power amplifier (PA) in a delta sigma modulator (DSM) that is located in the transmitting device (BS), said signals are transmitted over at least one optical fiber (OF1) from the transmitting device (BS) to the at least one receiving device (RAH1), and said signals are amplified in a second part of the switched mode power amplifier (PA) in a switched output stage (SOS) that is located in said at least one receiving device (RAH1), a switched mode power amplifier, a transmitting device, a receiving device, and a communication network therefor.

## Description

The invention relates to a method for transmission of signals according to the preamble of claim 1, a switched mode power amplifier according to the preamble of claim 5, a transmitting device according to the preamble of claim 8, a receiving device according to the preamble of claim 11, and a communication network according to the preamble of claim 14.

The coverage of a certain service area in a cellular radio network is provided by several radio base stations, which are connected to a core network to serve connections to and from mobile users within the service area. A radio base station contains a baseband unit and at least one antenna unit. In order to increase radio coverage and capacity, modern base stations use several sector antennas.

In order to increase flexibility of the base stations, it is desirable to allow the antennas to be located remote from the baseband unit. This has lead to the development of active antenna systems which are also termed remote antenna heads. Typically, one remote antenna head contains one sector antenna, but there are also systems known, which have remote antenna heads with more than only one sector antenna.

The base stations are preferably connected with the remote antenna heads by means of optical fibers. Conventional radio-over-fiber scenarios involve optical transmission of analogue signals between a base station and a transmitter with an amplifier in a remote antenna head.

An example for the implementation of a radio-over-fiber concept in a cellular radio network using a two-fiber-ring is given in the European patent EP 1553791 B1.

However, the quality of the optical transmission suffers severely from noise, non-linearities, like e.g. chromatic dispersion, and attenuation effects. Consequently the technical implementations for radio-over-fiber concepts must involve highly sophisticated optical modulation techniques and signal conditioning.

Basically, the transmission of analogue radio frequency signals involves high electronic efforts for signal modulation techniques and signal conditioning. Indeed, e.g. the method of intensity modulation and direct detection is straightforward, simple and allows for fairly linear optical transmission properties, but on the other hand it requires costly modulators and modulator drivers in order to meet the requirements for analogue radio frequency transmission. In case double side band modulation is used, chromatic dispersion will result in frequency and length dependent suppression of radio frequency power, which will deteriorate the transmission quality.

The object of the invention is thus to propose a cost-effective and fault-tolerant method for transmission of signals from a transmitting device to at least one receiving device using a power amplifier for signal amplification with an optical connection between the transmitting device and the at least one receiving device.

This object is achieved by a method according to the teaching of claim 1, a switched mode power amplifier according to the teaching of claim 5, a transmitting device according to the teaching of claim 8, a receiving device according to the teaching of claim 11, and a communication network according to the teaching of claim 14.

As mobile communication systems like e.g. Universal Mobile Telecommunications System (UMTS), Worldwide Interoperability for Microwave Access (WIMAX), or Third Generation Partnership Project Long Term Evolution (3GPP LTE) require power amplifiers with high output power at frequencies up to 2.6 GHz, preferably so-called class S power amplifiers, which comprise so-called class D/E/F output stages, are used for signal amplification. In said class S power amplifiers, the transistor is not amplifying the input signal linearly, but is acting as a switch in the ideal case. As an ideal switch does not dissipate power, a power efficiency of 100% is theoretically reachable.

The main idea of the invention is to exploit the existence of a digital signal path inside the existing switched mode power amplifier concept for optical transmission of radio frequency signals by dividing the switched mode power amplifier into two remote parts connected by an optical link, as digital signals are more fault-tolerant against interferences than analogue signals.

The invention enables transmission of digital instead of analogue signals by drawing use from a digital signal path which is already existing inside switched mode power amplifiers. As a digital signal which is already available within the switched mode power amplifiers is used, there is no need for additional costly high speed analogue-to-digital and digital-to-analogue conversion. Thus, compared with conventional radio-over-fiber scenarios, at zero additional costs all the concepts for optical transmission of digital signals can be applied to radio-over-fiber applications.

For transmission of signals from a base station via at least one remote antenna head to a user terminal, a switched mode power amplifier for signal amplification is used, and the signals are transmitted over at least one optical connection from the base station to the at least one remote antenna head.

According to the invention the signals are modulated in a first part of the switched mode power amplifier in a delta sigma modulator that is located in the base station, the signals are converted from electrical signals into optical signals in an electro-optical converter in the first part of the switched mode power amplifier, the signals are converted from optical signals into electrical signals in an opto-electrical converter in a second part of the switched mode power amplifier that is located in said at least one remote antenna head, and said signals are amplified in the second part of the switched mode power amplifier in a switched output stage.

Further developments of the invention can be gathered from the dependent claims and the following description.

In the following the invention will be explained further making reference to the attached drawings.
Fig. 1 schematically shows a cellular communication network with a base station and remote antenna heads in which the invention can be implemented.
Fig. 2 schematically shows a switched mode power amplifier architecture relying on a voltage switched circuit topology according to the state-of-the-art.
Fig. 3 schematically shows a delta sigma modulator according to the state-of-the-art.
Fig. 4 schematically shows a switched mode power amplifier with a delta sigma modulator, a switched output stage and a filter according to the state-of-the-art.
Fig. 5 schematically shows a switched mode power amplifier that is divided into two parts located in a base station and in a remote antenna head respectively according to the invention.

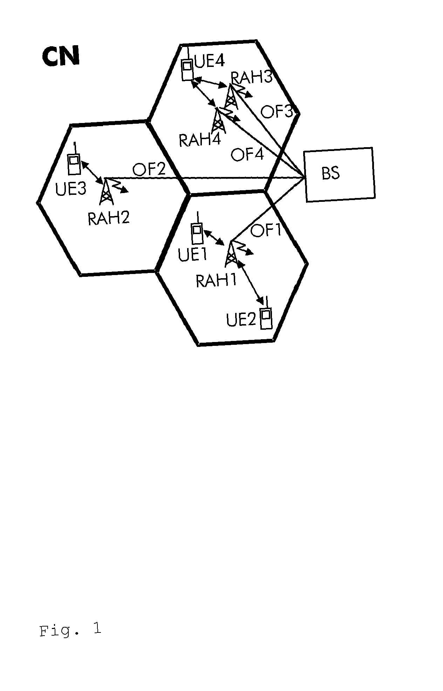

The principle structure of a communication network CN for signal transmission and reception in which the invention can be implemented is shown in fig. 1. The communication network CN comprises a base station BS, remote antenna heads RAH1-RAH4 and user terminals UE1-UE4.

Each of said remote antenna heads RAH1-RAH4 is connected to the base station BS by means of an optical connection, as e.g. an optical fiber or an optical free-space connection, OF1, OF2, OF3 and OF4 respectively. Each of said user terminals UE1-UE4 is connected to one or multiple of said remote antenna heads RAH1-RAH4, which is symbolized by double arrows in fig. 1. The base station BS is in turn connected to a core network, which is not shown in fig. 1 for the sake of simplicity.

For amplification of signals that shall be transmitted from the base station BS via a remote antenna head RAH1-RAH4 to a user terminal UE1-UE4, preferably switched mode power amplifiers are used that are preferably located in the remote antenna heads RAH1-RAH4.

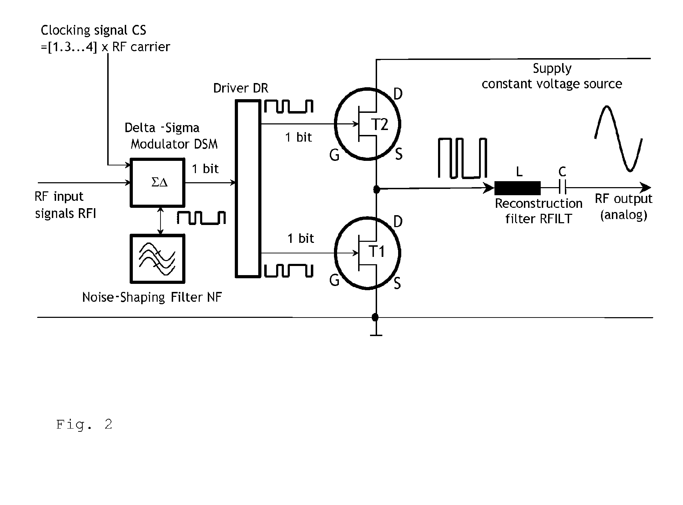

As an example for a switched mode power amplifier, a voltage switched power amplifier system according to the state-of-the-art is shown in fig. 2. Such a voltage switched power amplifier system comprises a delta-sigma modulator DSM with inputs for reception of an analogue radio frequency input signal RFI and for reception of a clocking signal CS. An output of the delta-sigma modulator DSM is connected to an input of a driver DR.

Preferably, the delta-sigma modulator DSM is connected to a noise-shaping filter NF or comprises a noise shaping filter.

A first output of the driver DR is connected to the gate G of a first transistor T1, and a second output of the driver DR is connected to the gate G of a second transistor T2.

The source S of the first transistor T1 is connected to ground, and the source of the second transistor T2 is connected to the drain of the first transistor T1.

The drain of the first transistor T1 and the source of the second transistor T2 are connected to an radio frequency output via a reconstruction filter RFILT that comprises an inductor L and a capacitor C in series. There are variants of the L-C filter topology which however are of no importance for the invention as disclosed.

The drain of the second transistor T2 is connected to the supply of a constant voltage source.

In a method for signal amplification using a voltage switched power amplifier system according to the state-of-the-art as shown in fig. 2, analogue radio frequency input signals are sent to the delta-sigma modulator DSM. Furthermore, clocking signals with a multiple of the radio frequency carrier frequency are sent to the delta-sigma modulator DSM.

In the delta-sigma modulator DSM, the analogue radio frequency input signals are converted into digital 1-bit or higher resolution signals. The sampling rate is determined by the received clocking signals. The digital 1-bit or multibit signals are provided at the output of the delta-sigma modulator DSM.

Preferably, the noise shaping filter NF is used to minimize quantization error by means of shifting quantization noise into frequency ranges that are less or not relevant for signal processing.

Said digital 1-bit signals are sent to the driver DR that generates first driver signals based on the digital 1-bit signals and second driver signals based on the inverted digital 1-bit signals. The first driver signals are sent to the gate of the second transistor T2, and the second driver signals are sent to the gate of the first transistor T1. The output signals of the driver DR are thus in antiphase which means if the first transistor T1 is on, the second transistor T2 is off and vice versa. The described amplifier architecture with two transistors T1, T2 is just an example, and in alternative architectures, more than two transistors are used, which has however no influence on the invention. Such alternative architectures are e.g. multibit architectures, using two transistors more per each bit more.

The capacitor C and the inductor L together build a reconstruction filter RFILT used to generate smooth analogue output signals that are provided at the radio frequency output.

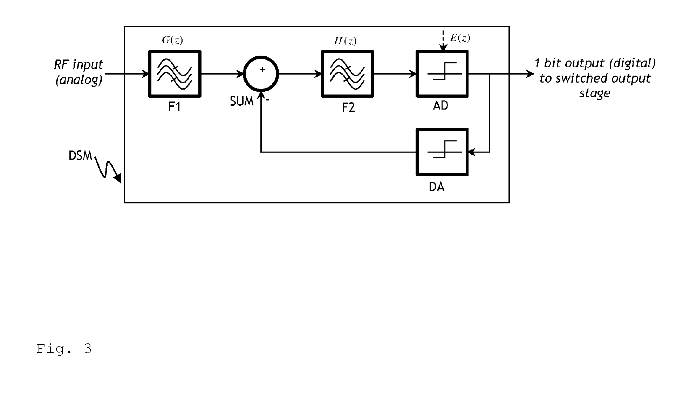

Fig. 3 is illustrating a delta sigma modulator DSM according to the state-of-the-art. The delta sigma modulator DSM comprises a filter F1, a summer SUM, a noise shaping filter F2, an analog-to-digital converter AD and a digital-to-analog converter DA.

The filter F1 has an input for receiving analogue input signals. The output of the filter F1 is connected to a first input of the summer SUM.

The output of the summer SUM is connected to the input of the noise shaping filter F2, and the output of the noise shaping filter F2 is connected to the input of the analog-to-digital converter AD.

The output of the analog-to-digital converter AD is on the one hand connected to the input of the digital-to-analog converter DA, and can on the other hand be connected to an external device, as e.g. the driver D of the switched output stage in fig. 2, for transmitting digital output signals.

The output of the digital-to-analog converter DA is connected to a second, inverting, input of the summer SUM.

In principle, an analogue radio frequency input signal is encoded in the delta sigma modulator DSM into a two level digital output sequence that is appropriate for driving a switched output stage of a switched mode amplifier.

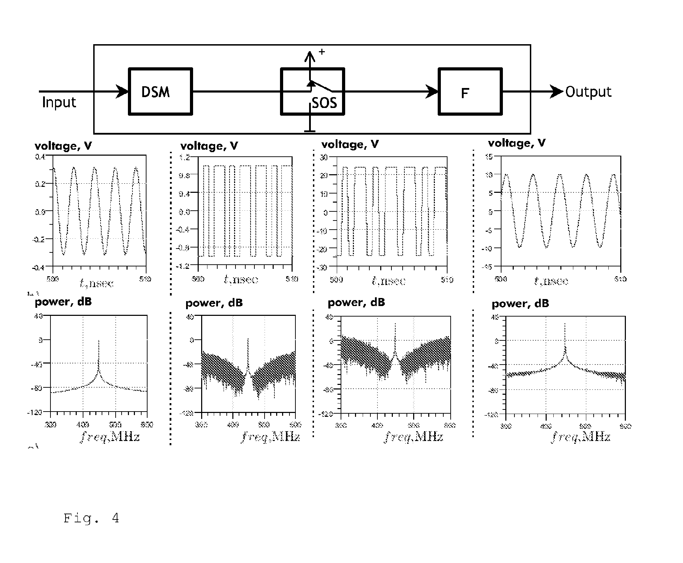

Fig. 4 is illustrating in the upper row schematically a switched mode power amplifier according to the state of the art that comprises a delta sigma modulator DSM, a switched output stage SOS, and a filter F. The switched output stage SOS comprises e.g. the driver DR and the two transistors T1 and T2 as depicted in fig. 2. However, as the described amplifier architecture with one driver DR and two transistors T1, T2 in fig. 2 is just an example, in alternative architectures, only one transistor or more than two transistors with more than one driver are used, i.e. the switched output stage SOS can comprise an arbitrary number of drivers and transistors, which has however no influence on the invention.

The delta sigma modulator DSM has an input for receiving input signals. The output of the delta sigma modulator DSM is connected to the input of the switched output stage SOS.

The output of the switched output stage SOS is connected to the input of the filter F, and the filter F comprises an output for transmitting output signals.

In the middle row, 4 diagrams are showing the signal voltage in volts versus time in nanoseconds from left to right for signals at the input of the delta sigma modulator DSM, at the output of the delta sigma modulator DSM, at the output of the switched output stage SOS, and at the output of the filter F.

In the lower row, 4 diagrams are showing the signal power density spectrum in decibels versus frequency in megahertz from left to right for signals at the input of the delta sigma modulator DSM, at the output of the delta sigma modulator DSM, at the output of the switched output stage SOS, and at the output of the filter F.

As can be seen from the first two diagrams in the middle row, the delta sigma modulator converts analogue signals into digital signals, and according to the invention, said digital signals will be transmitted over an optical connection to the switched output stage SOS that is remotely located in a remote antenna head.

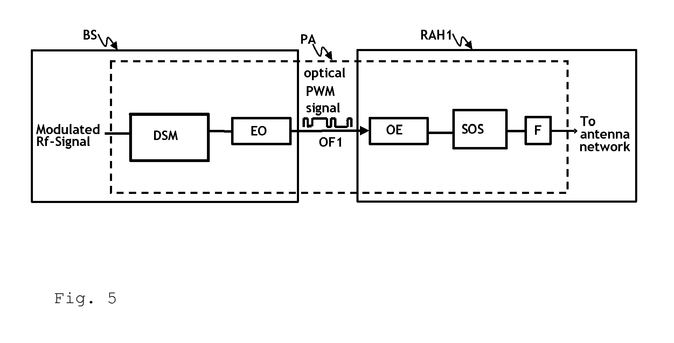

A switched mode power amplifier PA according to the invention is depicted in fig. 5. The switched mode power amplifier PA is indicated as a dashed box and comprises a delta sigma modulator DSM, an electro-optical converter EO, an opto-electrical converter OE, a switched output stage SOS and a filter F. The switched output stage in turn comprises at least one driver and at least one transistor as described above under fig. 4.

The delta sigma modulator DSM has an input for receiving analogue input signals. An output of the delta sigma modulator DSM is connected to an input of the electro-optical converter EO.

An output of the electro-optical converter EO is connected to an input of the opto-electrical converter OE through an optical connection OF1.

In an embodiment of the invention, a further device for signal conditioning, as e.g. an equalizer or a pre-amplifier, is comprised in the signal path between the electro-optical converter EO and the switched output stage SOS.

An output of the opto-electrical converter OE is connected to an input of the switched output stage SOS, and an output of the switched output stage SOS is connected to an input of the filter F.

In an embodiment of the invention, a further device for signal conditioning, as e.g. an equalizer or a pre-amplifier, is comprised in the signal paths between the electro-optical converters EO and the opto-electrical converter OE, or in the signal path between the opto-electrical converter OE and the switched output stage SOS.

An output of the filter F in turn is connected to an antenna network, which is not depicted in fig. 5 for the sake of simplicity.

In the embodiment depicted in fig. 5, the delta sigma modulator DSM and the electro-optical converter EO are comprised in a base station BS, which is indicated as a box, and the opto-electrical converter OE, the switched output stage SOS and the filter F are comprised in a remote antenna head RAH1, which is also indicated as a box.

In the delta sigma modulator DSM, analogue radio frequency signals that the delta sigma modulator DSM receives at its input are converted into digital signals. Said digital signals are sent to the electro-optical converter EO for converting the digital electrical signals into digital optical signals. Preferably, said electro-optical converter EO comprises a laser diode which is either directly modulated or externally modulated e.g. by means of a electroabsorption or lithiumniobate modulator.

From the output of the electro-optical converter EO, the digital optical signals, as e.g. PWM signals (PWM = Pulse Width Modulation), are sent over the optical connection OF1 to an input of the opto-electrical converter OE.

In the opto-electrical converter OE, the digital optical signals are back-converted into digital electrical signals. Preferably, said opto-electrical converter OE comprises a so-called PIN-diode or a so-called avalanche-photo-diode. The digital electrical signals are sent from an output of the opto-electrical converter OE to an input of the switched output stage SOS.

In the switched output stage SOS, the digital electrical signals drive at least one transistor via at least one driver, which leads to amplified digital electrical signals at the output of the switched output stage SOS.

Said amplified digital electrical signals are sent to the input of the filter F, and by means of said filter F, the amplified analogue radio frequency signals are reconstructed and sent via the output of the filter F to the antenna network for transmission over an air interface.

In the embodiment described above, the opto-electrical converter OE, and the switched output stage SOS are depicted as two distinct devices. However, in further embodiments of the invention, the opto-electrical converter OE, and the switched output stage SOS can also be colocated, i.e. they are two parts of one device. An example for such colocated devices is the vertical integration of an avalanche-photo-diode with a high electron mobility transistor (HEMT). In this example, the opto-electrical converter OE is realized as an avalanche-photo-diode, and the switched output stage SOS is realized as a high electron mobility transistor (HEMT).

In an embodiment of the invention, signals from the base station BS are transmitted through at least two optical connections OF3, OF4 via at least two remote antenna heads RAH3, RAH4 to a user terminal UE4 applying so-called beamforming or multiple-input-multiple-output, as depicted in fig. 1 for the case of two remote antenna heads RAH3 and RAH4 that are used for signal transmission to the user terminal UE4.

Such a switched mode power amplifier PA according to the invention can be used e.g. for a communication network applying the standard Universal Mobile Telecommunications System, Third Generation Partnership Project Long Term Evolution, or Worldwide Interoperability for Microwave Access.

In the embodiments above, the invention is described for the transmission of signals from a base station BS via at least one remote antenna head RAH1 to a user terminal UE1, however the invention is also applicable for transmission of signals from an arbitrary transmitting device to an arbitrary receiving device, as e.g. used in a point-to-point radio system or used for connection of devices within a rack.

## Claims

1. A method for transmission of signals from a transmitting device (BS) to at least one receiving device (RAH1) using a switched mode power amplifier (PA) for signal amplification, wherein said signals are transmitted over at least one optical connection (OF1) from the transmitting device (BS) to the at least one receiving device (RAH1) **characterized in, that**
• the signals are modulated in a first part of the switched mode power amplifier (PA) in a delta sigma modulator (DSM) that is located in the transmitting device (BS),
• the signals are converted from electrical signals into optical signals in an electro-optical converter (EO) in the first part of the switched mode power amplifier (PA),
• the signals are converted from optical signals into electrical signals in an opto-electrical converter (OE) in a second part of the switched mode power amplifier (PA) that is located in said at least one receiving device (RAH1),
• and said signals are amplified in the second part of the switched mode power amplifier (PA) in a switched output stage (SOS).

2. A method according to claim 1, **characterized in, that** said transmitting device (BS) is a base station (BS) and said at least one receiving device (RAH1) is a remote antenna head (RAH1), and said signals are transmitted from the base station (BS) via the at least one remote antenna head (RAH1) to a user terminal (UE1).

3. A method according to claim 2, **characterized in, that** signals from the base station (BS) are transmitted via at least two remote antenna heads (RAH3, RAH4) to a user terminal (UE4) applying beamforming or multiple-input-multiple-output.

4. A method according to claim 1, **characterized in, that** said signals are conditioned in a device for signal conditioning in the signal path between the electro-optical converter (EO) and the switched output stage (SOS).

5. A switched mode power amplifier (PA) **characterized in, that**
• a first part of the switched mode power amplifier (PA) comprises a delta sigma modulator (DSM) and an electro-optical converter (EO),
• a second part of the switched mode power amplifier (PA) comprises an opto-electrical converter (OE) and a switched output stage (SOS),
• and said first and second part of the switched mode power amplifier (PA) are connected through an optical connection (OF1).

6. A switched mode power amplifier (PA) according to claim 5, **characterized in, that** the switched mode power amplifier (PA) comprises a class D, E or F switched output stage (SOS).

7. A switched mode power amplifier (PA) according to claim 5, **characterized in, that** the electro-optical converter (EO) comprises a modulator.

8. A transmitting device (BS) for transmission of signals to at least one receiving device (RAH1) **characterized in, that** said transmitting device (BS) comprises as a first part of a switched mode power amplifier (PA) a delta sigma modulator (DSM) that is connected via an electro-optical converter (EO) to an optical output of the transmitting device (BS).

9. A transmitting device (BS) according to claim 8, **characterized in, that** said transmitting device (BS) is a base station (BS) for transmission of signals via a remote antenna head (RAH1) to a user terminal (UE1).

10. A transmitting device (BS) according to claim 9, **characterized in, that** the transmitting device (BS) is used for a communication network applying the standard Universal Mobile Telecommunications System, Third Generation Partnership Project Long Term Evolution, or Worldwide Interoperability for Microwave Access.

11. A receiving device (RAH1) for reception of signals sent from a transmitting device (BS) **characterized in, that** said receiving device (RAH1) comprises as a second part of a switched mode power amplifier (PA) an optical input that is connected via an opto-electrical converter (OE) to a switched output stage (SOS) of said switched mode power amplifier (PA).

12. A receiving device (RAH1) according to claim 11, **characterized in, that** said receiving device (RAH1) is a remote antenna head (RAH1) for reception of signals sent from a base station (BS) .

13. A receiving device (RAH1) according to claim 12, **characterized in, that** the receiving device (RAH1) is used for a communication network applying the standard Universal Mobile Telecommunications System, Third Generation Partnership Project Long Term Evolution, or Worldwide Interoperability for Microwave Access.

14. A communication network (CN) comprising at least one base station (BS) and at least one remote antenna head (RAH1) for transmission of signals from said base station (BS) via said remote antenna head (RAH1) to a user terminal (UE1) **characterized in, that**
• said at least one base station (BS) comprises as a first part of a switched mode power amplifier (PA) a delta sigma modulator (DSM) that is connected via an electro-optical converter (EO) to an optical output of said at least one the base station (BS),
• said at least one remote antenna head (RAH1) comprises as a second part of the switched mode power amplifier (PA) an optical input that is connected via an opto-electrical converter (OE) to a switched output stage (SOS) of said switched mode power amplifier (PA),
• and said at least one base station (BS) is connected through an optical connection (OF1) with said at least one remote antenna head (RAH1).
